# FASCICULE DE BREVET EUROPEEN

(11) **EP 1 303 043 B1**
(45) Date de publication et mention de la délivrance du brevet: **27.03.2013**
(21) Numéro de dépôt: 02079179.4
(22) Date de dépôt: 09.10.2002
(51) Int. Cl.: H03K 5/1252

(54) **Filtre digital pour reduire des pics de tension**
Digitales Filter zur Verminderung von Spannungsspitzen
Digital filter for suppressing glitches

(30) Priorité: 16.10.2001 FR 0113333
(43) Date de publication de la demande: 16.04.2003
(73) Titulaire: ST-Ericsson SA, 1228 Plan-les-Ouates (CH)
(72) Inventeur: Bonafos, Xavier-David, 75008 Paris (FR); Tanguy, Jean-Michel, 75008 Paris (FR)
(74) Mandataire: Schuffenecker, Thierry

(56) Documents cités:
- EP-A- 0 604 126
- US-A- 5 418 486
- US-B1- 6 184 719
- PATENT ABSTRACTS OF JAPAN vol. 006, no. 025 (E-094), 13 février 1982 (1982-02-13) & JP 56 146323 A (SHARP CORP), 13 novembre 1981 (1981-11-13)
- PATENT ABSTRACTS OF JAPAN vol. 014, no. 051 (E-0881), 30 janvier 1990 (1990-01-30) & JP 01 277020 A (MITSUBISHI ELECTRIC CORP), 7 novembre 1989 (1989-11-07)
- PATENT ABSTRACTS OF JAPAN vol. 2000, no. 13, 5 février 2001 (2001-02-05) & JP 2000 295083 A (FUJIKURA LTD), 20 octobre 2000 (2000-10-20)

## Description

La présente invention concerne un filtre digital apte à recevoir un signal numérique d'entrée, comportant un détecteur de front montant, un détecteur de front descendant, une ligne à retard adaptée pour retarder ledit signal numérique d'entrée, ledit signal numérique d'entrée comprenant un pic de tension. Elle concerne également un procédé de filtrage digital adapté pour filtrer des pics de tension compris dans ledit signal numérique.

Elle trouve une application particulière notamment dans les téléphones mobiles.

Le brevet US 5,878,094 publié le 2 mars 1999, décrit un circuit de filtrage de signal numérique apte à recevoir un signal d'entrée et apte à produire un signal de sortie. Le circuit de filtrage comprend une ligne à retard, un détecteur de front montant et un détecteur de front descendant agencés de telle sorte qu'ils empêchent le signal d'entrée de revenir à un état précédent pendant une durée limitée juste après que ledit signal a changé d'état. Par conséquent, s'il existe un pic de tension pendant cette durée limitée, ce dernier est filtré.

Bien que cet état de la technique permette de filtrer un pic de tension, il ne filtre les pics de tension que pendant une durée limitée après un changement de front. Par conséquent, dans le cas où un pic de tension apparaîtrait au milieu d'un état haut ou bas, il ne serait pas filtré.

Le brevet US 5,418,486, publié le 23 Mai 1995, décrit un circuit de filtrage de signal numérique apte à supprimer une impulsion de bruit ayant une largeur inférieure à une durée prédéterminée, comprenant une ligne à retard, un circuit de combinaison et trois moyens distincts de mixage.

Aussi un problème technique à résoudre par l'objet de la présente invention est de proposer un filtre digital apte à recevoir un signal numérique d'entrée, comportant un détecteur de front montant, un détecteur de front descendant, une ligne à retard adaptée pour retarder ledit signal numérique d'entrée, ledit signal numérique d'entrée comprenant un pic de tension, ainsi qu'un procédé de traitement de signal numérique associé, qui permettent de supprimer un pic de tension dudit signal numérique d'entrée et ce à n'importe quel moment d'un état haut ou bas dudit signal numérique d'entrée.

Une solution au problème technique posé se caractérise, selon un premier objet de la présente invention, par les caractéristiques du filtre digital selon la revendication 1.

Selon un second objet de la présente invention, cette solution se caractérise par les caractéristiques du procédé de traitement du signal numérique selon la revendication 6.

Ainsi, comme on le verra en détail plus loin, un tel filtre digital permet de supprimer un pic de tension à tout instant. De plus, il présente l'avantage de ne pas utiliser d'horloge externe. Enfin, il présente l'avantage d'utiliser des moyens simples.

La description qui suit, en regard des dessins annexés, le tout donné à titre d'exemples non limitatifs, fera bien comprendre en quoi consiste l'invention.
- la Fig. 1 illustre de façon schématique une architecture du filtre digital selon l'invention,
- la Fig. 2 est un premier diagramme représentant un signal d'entrée numérique, des signaux indicateur de front, des signaux de filtrage indicateurs de front et un signal de sortie gérés par le filtre digital de la figure 1,
- la Fig. 3 un deuxième diagramme représentant un signal d'entrée numérique comportant plusieurs pics de tension entre deux états, des signaux indicateurs de filtrage de front montant et de front descendant et un signal de sortie, gérés par le filtre digital de la figure 1,
- la Fig. 4 est un diagramme représentant un phénomène d'effet de bord sur les signaux gérés par le filtre digital de la figure 1, et
- la Fig. 5 représente un mode de réalisation du filtre digital de la figure 1.

Le présent exposé de l'invention a trait à un exemple de filtre digital utilisé dans le domaine de la téléphonie mobile. Un téléphone portable appelé également mobile comporte un module RTC servant à contrôler une montre donnant l'heure. Ce module est appelé également en langue anglaise "Real Time Clock". Le module RTC comprend des connexions PAD et un générateur de signal carré CLK. Une connexion PAD comprend un oscillateur qui couplé avec un quartz externe crée un signal analogique sinusoïdal à fréquence fixe de 32 kHz. Le générateur de signal carré CLK (également appelé dans la langue anglaise "dock squarrer") qui sert d'horloge interne, transforme ce signal analogique sinusoïdal en signal numérique d'entrée INPUT(G). Un oscillateur est un composant sensible, par exemple à des pics de courant dans le module RTC, et à des facteurs électromagnétiques. Cette sensibilité se traduit par une déformation du signal sinusoïdal. Cette déformation entraîne une apparition de pics de tension G (couramment appelés dans la langue anglaise "glitch") dans le signal numérique d'entrée INPUT(G). A la sortie du générateur de signal carré CLK, pour fournir un signal exempt de pics de tension G, le filtre digital FILT est intégré dans ledit module RTC.

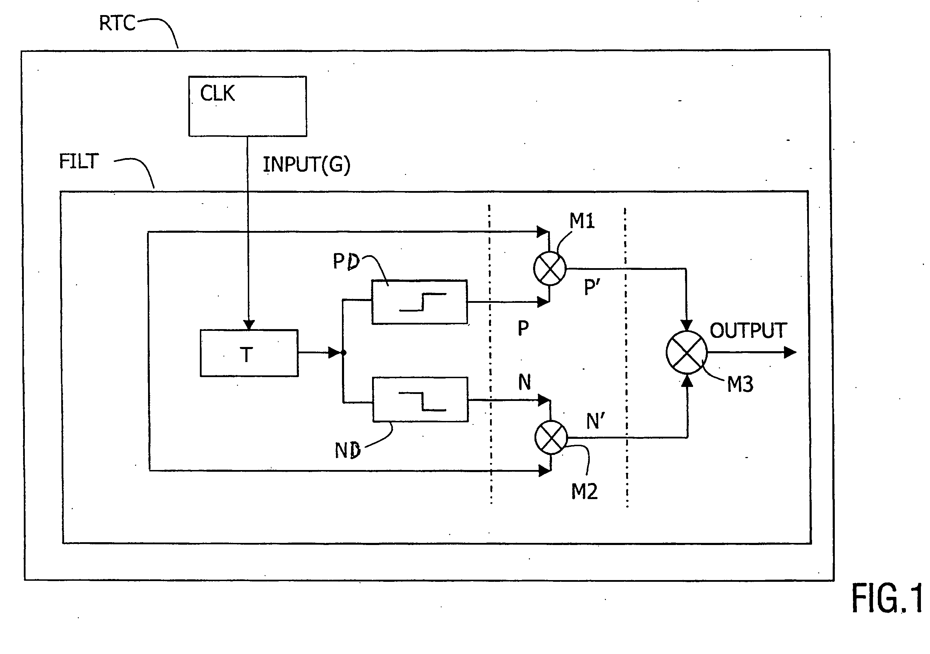

Sur la figure 1 est représenté un schéma d'une architecture du filtre digital FILT. Ledit filtre comporte :
- une ligne à retard T,
- un détecteur de front montant PD,
- un détecteur de front descendant ND,
- des premiers moyens de mixage M1,
- des deuxièmes moyens de mixage M2,
- des troisièmes moyens de mixage M3.

Le filtre reçoit le signal numérique d'entrée INPUT(G) pouvant comporter des pics de tension. Ces pics de tension peuvent être nocifs au bon fonctionnement de la montre du téléphone mobile. En effet, en raison des pics de tension, la montre avance de quelques secondes en trop. L'heure ainsi marquée sur la montre n'est pas exacte.

Afin d'éviter d'avoir des pics de tension, ledit signal numérique est traité selon les étapes décrites ci-après. On fait les hypothèses suivantes.
- Un pic de tension G possède une durée maximale connue qui est de 10 ns dans le cas de l'application donnée à titre d'exemple. Elle pourrait être de 2ns dans des systèmes plus rapides.
- Un pic de tension G possède une durée qui est petite par rapport à la durée d'un état haut ou bas du signal d'entrée INPUT(G). En général, un pic de tension G sera inférieur à 10ns. Ici, dans l'application donnée à titre d'exemple, il dure 5ns et un état haut ou bas doit rester stable pendant 15 600ns.
- Aucune horloge externe n'est utilisée.

De plus, dans un premier temps, on fait l'hypothèse qu'un seul pic de tension G apparaît entre deux fronts du signal d'entrée.

On notera que pour connaître la durée d'un pic de tension G pour une certaine application, il est nécessaire de faire des tests en laboratoire, connus de l'homme du métier, à l'aide de moyens de vérification tels qu'un oscilloscope et tels que du code compilé compris dans le module RTC, ledit code compilé se trouvant généralement dans un processeur (non représenté), ledit processeur permettant de contrôler ledit module RTC de manière connue de l'homme du métier.

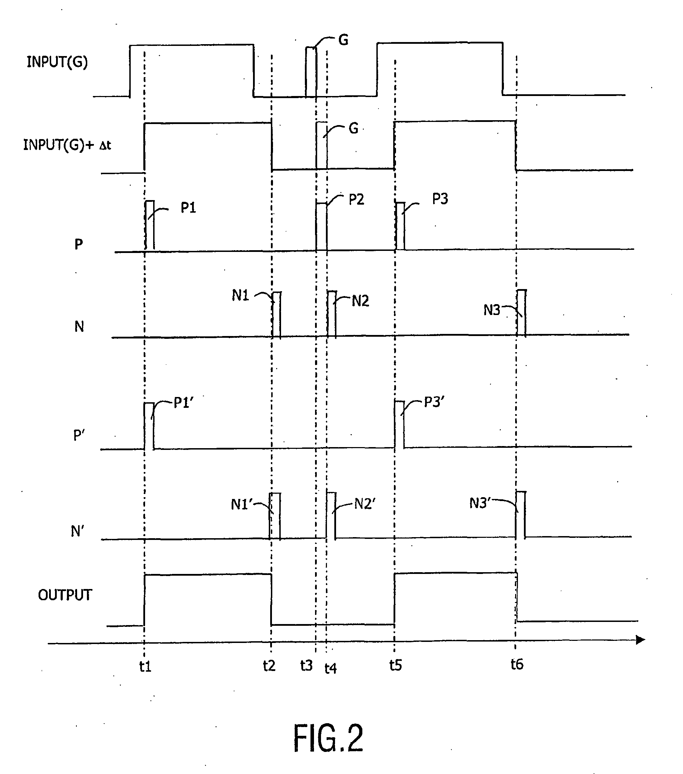

Dans une première étape, lorsque le filtre digital FILT reçoit un signal numérique d'entrée INPUT(G), la ligne à retard T retarde ce signal numérique d'un retard Δt supérieur ou égal à la durée d'un pic de tension G. La durée du retard Δt est de préférence de 10ns pour l'application donnée à titre d'exemple i.e. celle du mobile. Comme on peut le voir sur la figure 2, on obtient un signal numérique retardé INPUT(G) + Δt.

Dans une deuxième étape, les détecteurs de front montant et de front descendant PD et ND détectent un front montant ou un front descendant à partir dudit signal numérique d'entrée retardé INPUT(G) + Δt. Ainsi, comme on peut le voir sur la figure 2, au temps t1, le détecteur de front montant PD détecte un front montant sur le signal d'entrée retardé INPUT(G)+ Δt et produit par la suite un signal indicateur de front montant P comportant une première impulsion P1. Il en est de même au temps t5 et au temps t3, le signal indicateur de front montant P comporte deux autres impulsions P2 et P3, le front montant détecté au temps t3 correspondant ici à un pic de tension G. De même, le détecteur de front descendant ND détecte au temps t2 un front descendant sur le signal d'entrée retardé INPUT(G)+ Δt et produit par la suite un signal indicateur de front descendant N comportant une première impulsion N1. Il en est de même au temps t4 et t6, le signal indicateur de front descendant N comporte deux autres impulsions N2 et N3, le front descendant détecté au temps t4 correspondant à un pic de tension G. Chaque impulsion d'un signal indicateur de front montant P ou d'un signal indicateur de front descendant N possède une durée minimale égale à 1ns pour l'application donnée à titre d'exemple. Pour plus de sûreté, on peut prendre une durée de 3ns.

Dans une troisième étape, les premiers moyens de mixage M1 produisent un signal de filtrage indicateur de front montant P' à partir du signal d'entrée INPUT(G) et du signal indicateur de front montant P. Lesdits premiers moyens de mixage M1 remplissent une fonction de ET logique. Ainsi, comme on peut le voir sur la figure 2, le signal de filtrage indicateur de front montant P' comporte deux impulsions P1' et P3', résultats de la fonction ET logique, respectivement aux temps t1 et t5. De la même manière, les deuxièmes moyens de mixage M2 produisent un signal de filtrage indicateur de front descendant N' à partir du signal d'entrée INPUT(G) et du signal indicateur de front descendant N. Lesdits deuxièmes moyens de mixage M2 remplissent également une fonction de ET logique à partir d'un signal d'entrée INPUT(G) inversé. Ils remplissent donc une fonction d'inverseur ensemble une fonction ET logique. Ainsi, le signal de filtrage indicateur de front descendant N' comporte trois impulsions N1', N2' et N3', résultats de la fonction ET logique, respectivement aux temps t2, t4 et t6. La durée des impulsions des signaux de filtrage P' ou N' est égale à celle des impulsions des signaux indicateurs de front montant ou descendant P ou N.

On notera que la fonction de ET logique entre le signal d'entrée INPUT(G) et les signaux indicateurs de front P et N, n'est efficace, i.e. ne permet de supprimer une impulsion de l'un ou l'autre desdits signaux indicateurs de front, impulsion correspondant à un pic de tension G, que si lesdits signaux indicateurs de front P ou N sont suffisamment retardés. Cela signifie que le retard Δt doit être au moins égal à la durée maximale d'un pic de tension G.

En effet, dans le cas où le retard Δt serait inférieur à la durée maximale d'un pic de tension G, la fonction de ET logique entre le signal d'entrée INPUT(G) et les signaux indicateurs de front ne permettrait pas de supprimer une impulsion de l'un ou l'autre desdits signaux indicateurs de front, impulsion correspondant à un pic de tension G. D'où la nécessité non seulement de retarder les signaux indicateurs de front montant et descendant P et N par rapport au signal numérique d'entrée INPUT(G) et par suite par rapport aux pics de tension G mais aussi de vérifier la durée du retard Δt.

Ainsi, à partir des signaux indicateurs de front montant et descendant P et N, on obtient des signaux de filtrage indicateurs de front montant et descendant P' et N' qui sont actifs respectivement uniquement sur les états haut et bas du signal numérique d'entrée INPUT(G).

Dans une dernière étape, les signaux de filtrage indicateurs de montant et descendant P' et N', sont utilisés pour produire un signal de sortie OUTPUT débarrassé de tout pic de tension G. Ainsi, les troisièmes moyens de mixage M3 reçoivent en entrée les signaux de filtrage indicateurs de front montant et descendant P' et N'. Lorsqu'une impulsion du signal de filtrage de front montant P' apparaît, lesdits troisièmes moyens de mixage M3 mettent à un le signal de sortie OUTPUT. Le signal de sortie OUTPUT demeure dans un état haut tant qu'il n'y aucune impulsion de signal de filtrage de front descendant N'. Dès qu'il y a une impulsion de signal de filtrage de front descendant N', les troisièmes moyens de mixage M3 mettent à zéro le signal de sortie OUTPUT. Le signal de sortie OUTPUT demeure dans un état bas tant qu'il n'y aucune impulsion de signal de filtrage de front montant P'.

Ainsi, comme on peut le voir sur la figure 2, au temps t1, le signal de filtrage indicateur de front montant P' comporte une première impulsion P1'. Aussi, le signal de sortie OUTPUT est-il mis à un. Au temps t2, le signal de filtrage indicateur de front descendant N' comporte une première impulsion N1'. Aussi, le signal de sortie OUTPUT est-il mis à zéro. Au temps t4, le signal de filtrage indicateur de front descendant N' comporte une deuxième impulsion N2'. Le signal de sortie OUTPUT demeure toujours dans un état bas. Au temps t5, le signal de filtrage indicateur de front montant P' comporte une deuxième impulsion P3'. Aussi, le signal de sortie OUTPUT est-il mis à un. Au temps t6, le signal de filtrage indicateur de front descendant N' comporte une troisième impulsion N3'. Aussi, le signal de sortie OUTPUT est-il mis à zéro. On obtient ainsi un signal numérique de sortie OUTPUT qui est équivalent au signal numérique d'entrée INPUT(G), retardé d'un retard Δt et sans aucun pic de tension G.

Ainsi, dans le cadre de l'application décrite, i.e. la montre du téléphone mobile, l'heure donnée est exacte.

On notera que le fait que le signal de sortie OUTPUT soit retardé par rapport au signal d'entrée INPUT(G) n'est pas gênant car le retard n'est que de quelques nanosecondes. Ce retard est tout à fait admissible pour le fonctionnement d'un module. De plus, dans l'application donnée à titre d'exemple, c'est le signal de sortie OUTPUT qui sert de référence pour les autres signaux utilisés par le module tels que le signal généré par le générateur de signal carré CLK. Ce signal donne les impulsions pour toutes communications internes dans le module RTC. Ainsi, le retard n'est perçu par aucun des signaux internes.

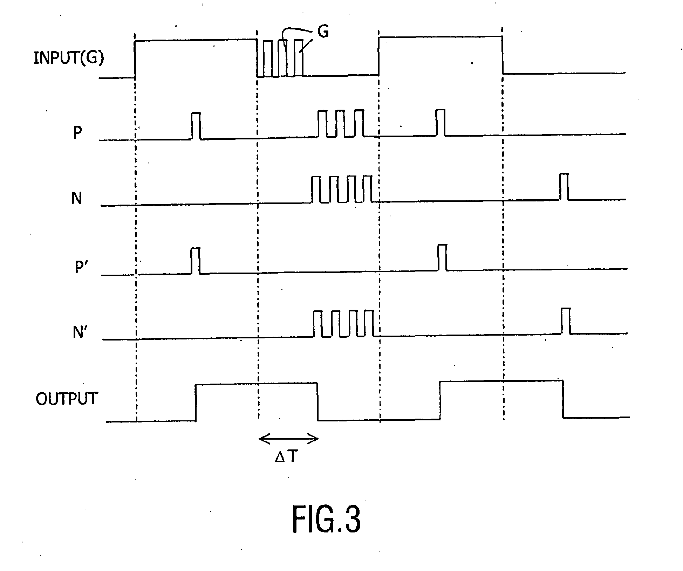

Par ailleurs, on notera que contrairement à l'hypothèse qui a été faite dans un premier temps sur la présence d'un seul pic de tension entre deux fronts, il se peut qu'une succession de pics de tension dans le signal numérique d'entrée INPUT(G) apparaisse. Cela survient lorsqu'un signal digital oscille fortement après avoir changé d'état. En effet, un signal digital peut présenter des oscillations sur ces états hauts ou bas. Quand il est transformé en signal numérique d'entrée INPUT(G), les oscillations se traduisent par plusieurs pics de tension rapprochés jusqu'à ce que lesdites oscillations correspondantes s'amortissent. Dans le cas où on aurait une telle succession de pics de tension G tels que représentés à la figure 3, il suffit d'augmenter la durée du retard Δt de sorte que ledit retard soit supérieur ou égal à toute la durée d'amortissement des oscillations.

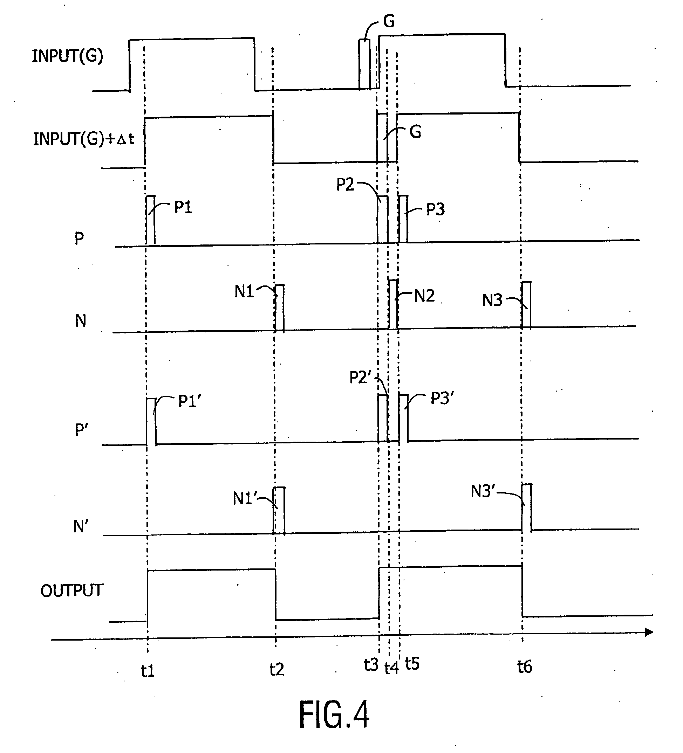

On remarquera qu'il peut se passer un phénomène d'effet de bord si un pic de tension G arrive juste avant un front montant ou descendant du signal numérique d'entrée INPUT(G). Comme on peut le voir sur la figure 4, dans ce cas, le pic de tension G peut se confondre avec le front montant et descendant ce qui a pour effet de faire apparaître le front montant ou descendant du signal de sortie OUTPUT correspondant trop tôt, ici un front montant au temps t3 au lieu du temps t5. Ce phénomène apparaît seulement si le retard entre la fin d'un pic de tension et le prochain front montant ou descendant du signal d'entrée INPUT(G) est inférieur au retard Δt, ce qui est rare. Cependant, si le phénomène arrive, cela ne change pas le fonctionnement du module RTC car le signal de sortie OUTPUT comporte une fréquence moyenne d'un cycle d'horloge égale à celle du signal d'entrée INTPUT(G).

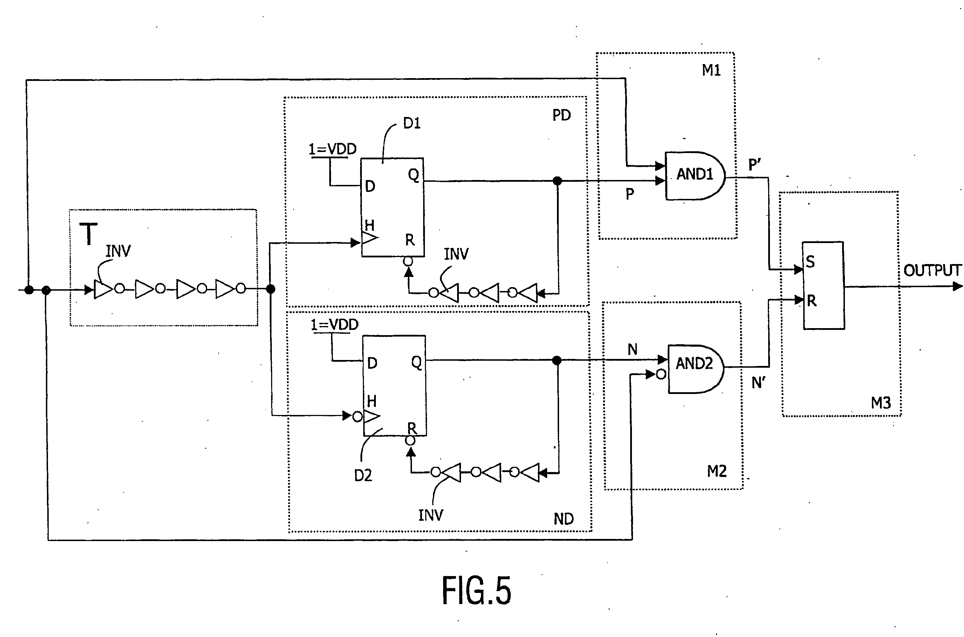

Dans un mode de réalisation non limitatif illustré à la figure 5, le filtre digital FILT est construit de la manière suivante.

La ligne à retard T comporte un nombre pair d'inverseurs INV, suffisant pour créer un retard d'une durée Δt. Ici, chaque inverseur INV possède un retard égal à Δt/4. Le nombre pair permet d'obtenir un signal d'entrée retardé INPUT(G)+Δt non inversé.
Le détecteur de front montant PD comprend une bascule D1 avec reset asynchrone et un branchement d'inverseurs INV de sa sortie Q sur son entrée reset R. L'entrée D est toujours à 1. Elle est alimentée par une alimentation VDD. La bascule D1 se déclenche à chaque front montant du signal d'entrée retardé INPUT(G)+Δt. On a normalement une table de correspondance qui est la suivante.

| H | D | Q | R |
|---|---|---|---|
| Front montant | 1 | 1 | 0 |

Comme on peut le voir sur la figure 5, le branchement comporte un nombre impair d'inverseurs INV. Ainsi, le signal sur la sortie Q est inversé et l'entrée reset R n'est active qu'à 0. Lorsque le signal sur la sortie Q est à 1, après le temps de propagation au travers des inverseurs INV, cela entraîne un reset asynchrone de la bascule D1. La sortie Q revient à 0. La bascule D1 génère donc une impulsion dont la durée est égale au temps de propagation des inverseurs INV.

Le détecteur de front descendant ND comprend une bascule D2 asynchrone, un nombre impair d'inverseurs INV en sortie et un inverseur INV à l'entrée de son entrée H. Cet inverseur à l'entrée permet à ladite bascule D2 de se déclencher à chaque front descendant du signal d'entrée retardé INPUT(G)+Δt. La bascule D2 fonctionne de la même manière que la bascule D1 présentée ci-dessus.

On notera que la durée de chaque impulsion d'un signal indicateur de front montant P ou d'un signal indicateur de front descendant N doit être de durée suffisante pour provoquer un changement d'état des troisièmes moyens de mixage M3. C'est pour cette raison que ladite durée doit être au minimum égale à 1ns pour l'application comme cela a été décrit auparavant.

Les premiers moyens de mixage M1 comportent une porte logique AND1 remplissant une fonction de ET logique. Lesdits premiers moyens M1 reçoivent en entrée le signal numérique d'entrée INPUT(G) non retardé et le signal indicateur de front montant P.

Les deuxièmes moyens de mixage M2 comportent une porte logique AND2 remplissant une fonction de ET logique ainsi qu'un inverseur INV à l'entrée de la porte logique AND2. Lesdits deuxièmes moyens M2 reçoivent en entrée le signal numérique d'entrée INPUT(G) non retardé et le signal indicateur de front descendant P'.

Les troisièmes moyens de mixage M3 sont une bascule RS. Cette bascule RS reçoit sur son entrée S le signal de filtrage indicateur de front montant P' et sur son entrée R le signal de filtrage indicateur de front descendant N'. Ladite bascule comprend une table de correspondance qui est la suivante.

| S | R | Q | *Q̅* | |
|---|---|---|---|---|
| 0 | 0 | Q | *Q̅* | (garde son état) |
| 0 | 1 | 0 | 1 | |
| 1 | 0 | 1 | 0 | |

| | | | | |
|---|---|---|---|---|
| 1 | 1 | X | X | (état interdit) |

Sur la figure 5, est représentée uniquement la sortie Q qui nous intéresse et qui produit le signal de sortie OUTPUT sans pic de tension G.

Dans le cas extrême où il y aurait plusieurs pic de tension G entre deux fronts, ce problème peut être résolu de manière certaine en mettant en cascade autant de filtres qu'il existe de pics G, chaque filtre supprimant de façon certaine au moins un pic de tension G. L'entrée d'un filtre correspond dans ce cas à la sortie du filtre précédent.

Ainsi le filtre digital, objet de l'invention revendiqué présente l'avantage de produire un signal sans pic de tension G, un pic de tension G inférieur au retard Δt étant éliminé et ce de manière simple, sans utiliser de moyens complexes analogiques tels que des capacités ou résistances. Ainsi, on utilise que des arrangements de transistors avec des bascules et portes logiques fournies par des librairies bien connues de l'homme du métier. Il n'y a pas d'analogique. En conséquence, il n'est pas besoin de faire appel à une équipe de placement routage pour connaître les délais et les distances entre deux portes.

Par ailleurs, aucun horloge externe n'a été utilisée.

Bien entendu, le cadre de l'invention n'est nullement limité aux modes de réalisation décrits ci-dessus et des variations ou modifications peuvent y être apportés sans pour autant s'écarter de la portée de l'invention comme défini par les revendications.

Bien entendu, l'invention n'est nullement limitée au domaine de la téléphonie mobile, elle peut s'étendre à d'autres domaines, notamment à tous ceux qui utilisent un filtre digital dans des modules tels que des asics ou des puces programmables FPGA, tels que les domaines "bluetooth", des réseaux sans fil, de l'imagerie, des équipements militaires....

Aucun signe de référence dans le présent texte ne doit être interprété comme limitant ledit texte.

Le verbe "comprendre" et ses conjugaisons ne doivent également pas être interprétés de façon limitative, i.e. ils ne doivent pas être interprétés comme excluant la présence d'autres étapes ou éléments outre ceux définis dans la description, ou encore, comme excluant une pluralité d'étapes ou d'éléments déjà listés après ledit verbe et précédés du mot "un" ou "une".

## Revendications

1. Filtre digital apte à recevoir un signal numérique d'entrée (INPUT(G)), comportant un détecteur de front montant (PD), un détecteur de front descendant (ND), une ligne à retard (T) adaptée pour retarder ledit signal numérique d'entrée (INPUT(G)) et produire un signal numérique d'entrée retardé (INPUT(G)+Δt), ledit signal numérique d'entrée (INPUT(G)) comprenant un pic de tension:
- ledit détecteur de front montant (PD) étant également adapté pour produire un signal indicateur de front montant (P) à partir du signal numérique d'entrée retardé (INPUT(G)+Δt), et
- ledit détecteur de front descendant (ND) étant également adapté pour produire un signal indicateur de front descendant (N) à partir du signal numérique d'entrée retardé (INPUT(G)+Δt),
ledit filtre comportant additionellement:
- des premiers moyens de mixage (M1) adaptés pour produire un signal indicateur de filtrage de front montant (P') à partir dudit signal numérique d'entrée (INPUT(G)) et dudit signal indicateur de front montant (P),
- des deuxièmes moyens de mixage (M2) adaptés pour produire un signal indicateur de filtrage de front descendant (N') à partir dudit signal numérique d'entrée (INPUT(G)) et dudit signal indicateur de front descendant (N), et
- des troisièmes moyens de mixage (M3) adaptés pour produire un signal numérique de sortie (OUTPUT) sans pic de tension à partir du signal indicateur de filtrage de front montant (P') et du signal indicateur de filtrage de front descendant (N').

2. Filtre digital selon la revendication 1, **caractérisé en ce que** le signal numérique d'entrée retardé (INPUT(G) + Δt) possède un retard (Δt) par rapport au signal numérique d'entrée (INPUT(G)) au moins égal à une durée maximale d'un pic de tension(G).

3. Filtre digital selon la revendication 1, **caractérisé en ce que** les premiers moyens de mixage (M1) remplissent une fonction de ET logique, et les deuxièmes moyens de mixage (M2) remplissent une fonction d'inverseur ensemble une fonction ET logique.

4. Filtre digital selon la revendication 1, **caractérisé en ce que** les troisièmes moyens de mixage (M3) sont une bascule RS.

5. Filtre digital selon la revendication 1, **caractérisé en ce que** les détecteurs de front montant (PD) et descendant (ND) sont des bascules D ayant un branchement d'inverseurs (INV) d'une sortie (Q) sur une entrée reset (R).

6. Procédé de filtrage d'un signal numérique (INPUT(G)) comprenant un pic de tension, ledit procédé comportant les étapes de :
- retarder ledit signal numérique d'entrée (INPUT(G)) et produire un signal numérique d'entrée retardé (INPUT(G)+Δt),
- détecter un front montant issu du signal numérique d'entrée retardé (INPUT(G)+Δt) et produire un signal indicateur de front montant (P),
- détecter un front descendant issu du signal numérique d'entrée retardé (INPUT(G)+Δt) et produire un signal indicateur de front descendant (N),
- produire un signal indicateur de filtrage de front montant (P') à partir dudit signal numérique d'entrée (INPUT(G)) et dudit signal indicateur de front montant (P),
- produire un signal indicateur de filtrage de front descendant (N') à partir dudit signal numérique d'entrée (INPUT(G)) et dudit signal indicateur de front descendant (N), et
- produire un signal numérique de sortie (OUTPUT) sans pic de tension à partir du signal indicateur de filtrage de front montant (P') et du signal indicateur de filtrage de front descendant (N').

7. Procédé de filtrage d'un signal numérique (INPUT(G)) selon la revendication 6, **caractérisé en ce que** le signal numérique d'entrée retardé (INPUT(G) + Δt) possède un retard (Δt) par rapport au signal numérique d'entrée (INPUT(G)) au moins égal à une durée maximale d'un pic de tension(G).

8. Module (RTC) comprenant un générateur de signal carré (CLK) transformant un signal analogique en un signal numérique d'entrée (INPUT(G)), **caractérisé en ce qu'**il comporte en outre un filtre digital tel que revendiqué dans la revendication 1 à 5 apte à recevoir ledit signal numérique d'entrée (INPUT(G)).

9. Téléphone portable comprenant un module (RTC) tel que revendiqué à la revendication 8.

## Claims

1. Digital filter for receiving a digital input signal (INPUT(G)), comprising a rising edge detector (PD), un falling edge detector (ND), a delay line (T) adapted for delaying said digital input signal (INPUT (G)) and for generating a delayed digital input signal (INPUT(G) + Δt), said digital input signal (INPUT(G)) comprising a voltage glitche,
- said rising edge detector (PD) being also adapted for generating a signal representative of a rising edge (P) from said delayed digital input signal (INPUT(G) + Δt), and
- said falling edge detector (ND) being also adapted for generating a signal representative of a falling edge (N) from said delayed digital input signal (INPUT(G) + Δt),
said filter further comprising:
- first mixing means (M1) adapted for generating a signal being indicative of the filtering of a rising edge (P') from said digital input signal (INPUT(G)) and said signal representative of the rising edge (P),
- second mixing means (M2) adapted for generating a signal indicative of the filtering of a falling edge (N') from said digital input signal (INPUT (G)) and said signal representative of the falling edge (N), and
- third mixing means (M3) adapted for generating a digital output signal (OUTPUT) without any voltage glitch from the signal indicative of the filtering of a rising edge (P') and the signal indicative of the filtering of a falling edge (N').

2. Digital filter according to claim 1, **characterized in that** the delayed digital input signal (INPUT(G) + Δt) comprises a delay (Δt) with respect to said digital input signal (INPUT(G)) which is at least equal to the maximum duration of a voltage glitche (G).

3. Digital filter according to claim 1, **characterized in that** said first mixing means (M1) carry out a logical AND function, and the second mixing means (M2) carry out an inverting function with a logical AND.

4. Digital filter according to claim 1, **characterized in that** said third mixing means (M3) are a RS latch.

5. Digital filter according to claim 1, **characterized in that** the rising edge detectors (PD) and the falling edge detectors (ND) are D-latches with a connexion of inverters (INV) between the output (Q) and the reset (R).

6. Filtering process of a digital signal (INPUT(G)) comprising a voltage glitche, said filtering process comprising the steps:
- delaying said digital input signal (INPUT(G)) and generating a delayed digital input signal (INPUT(G) + Δt),
- detecting a rising edge in the delayed digital input signal (INPUT(G) + Δt) and generating a signal indicative of a rising edge (P),
- detecting a falling edge in the delayed digital input signal (INPUT(G) + Δt) and generating a signal indicative of a falling edge (N),
- generating a signal being indicative of the filtering of a rising edge (P') from said digital input signal (INPUT(G)) and said signal representative of the rising edge (P),
- generating a signal indicative of the filtering of a falling edge (N') from said digital input signal (INPUT (G)) and said signal representative of the falling edge (N), and
- generating a digital output signal (OUTPUT) without any voltage glitch from the signal indicative of the filtering of a rising edge (P') and the signal indicative of the filtering of a falling edge (N').

7. Filtering process of a digital signal (INPUT(G)) according to claim 6, **characterized in that** the delayed digital input signal (INPUT(G) + Δt) comprises a delay (Δt) with respect to said digital input signal (INPUT(G)) which is at least equal to the maximum duration of a voltage glitche (G).

8. Module (RTC) comprising a squared signal generator (CLK) converting aan analog signal into a digital input signal (INPUT(G)), **characterized in that** it further comprises a digial filter claimed in anyone of claims 1 to 5, and able to receive said digital input signal (INPUT(G)).

9. Mobile telephone comprising a module (RTC) defined in claim 8.

## Patentansprüche

1. Digitales Filter, der fähig ist, ein digitales Eingangssignal (INPUT(G)) zu empfangen, mit einem Detektor der ansteigenden Flanke (PD), einem Detektor der abfallenden Flanke (ND), einer Verzögerungsstrecke (T), um das digitale Eingangssignal (INPUT(G)) zu verzögern und ein verzögertes digitales Eingangssignal (INPUT(G) + Δt) herstellen, wobei das digitale Eingangssignal (INPUT(G)) eine Spannungsspitze aufweist,
- wobei der Detektor der ansteigenden Flanke (PD) auch angepasst ist, um ein Anzeigesignal für ansteigende Flanke (P) herzustellen, ausgehend vom verzögerten digitalen Eingangssignal, (INPUT(G) + Δt), und
- besagter Detektor der abfallenden Flanke (ND) auch angepasst ist, um ein Anzeigesignal für abfallende Flanke (N) herzustellen, ausgehend vom verzögerten digitalen Eingangssignal (INPUT(G) + Δt),
wobei das Filter zusätzlich umfasst:
- erste Mischmittel (M1), um ein Filtrierungsanzeigesignal für ansteigende Flanke (P') herzustellen, ausgehend vom digitalen Eingangssignal (INPUT(G)) und vom genannten Anzeigesignal für ansteigende Flanke (P),
- zweite Mischmittel (M2), um ein Filtrierungsanzeigesignal für abfallende Flanke (N') herzustellen, ausgehend vom digitalen Eingangssignal (INPUT(G)) und vom genannten Anzeigesignal für abfallende Flanke (N), und
- dritte Mischmittel (M3), um ein digitales Ausgangssignal (OUTPUT) ohne Spannungsspitze herzustellen, ausgehend von dem Filtrierungsanzeigesignal für ansteigende Flanke (P') und dem Filtrierungsanzeigesignal für abfallende Flanke (N').

2. Digitales Filter nach Anspruch 1, **gekennzeichnet dadurch, dass** das verzögerte digitale Eingangssignal (INPUT(G) + Δt) eine Verspätung (Δt) in Bezug auf das digitale Eingangssignal (INPUT(G)) aufweist, deren Länge mindestens gleich der maximalen Dauer einer Spannungsspitze (G) ist.

3. Digitales Filter nach Anspruch 1, **gekennzeichnet dadurch, dass** die ersten Mischmittel (M1) die Funktion eines logischen UND haben und die zweiten Mischmittel (M2) die Funktion eines Wechselrichters und gleichzeitig die eines logischen UND.

4. Digitales Filter nach Anspruch 1, **gekennzeichnet dadurch, dass** die dritten Mischmittel (M3) ein RS-Flipflop sind.

5. Digitales Filter nach Anspruch 1, **gekennzeichnet dadurch, dass** die Detektoren der ansteigenden (PD) und der abfallenden Flanke (ND) D-Flip-Flops mit einem Wechselrichterzweig (INV) von einem Ausgang (Q) auf einem Reset-Eingang (R) aufweisen.

6. Filtrierungsverfahren für ein digitales Signal (INPUT(G)) mit einer Spannungsspitze, mit folgenden Phasen:
- das digitale Eingangssignal (INPUT(G)) verzögern und ein verzögertes digitales Eingangssignal (INPUT(G) + Δt) herstellen,
- eine ansteigende Flanke erkennen, die vom verzögerten digitalen Eingangssignal (INPUT(G) + Δt) stammt, und ein Anzeigesignal für ansteigende Flanke (P) herstellen,
- eine abfallende Flanke erkennen, die vom verzögerten digitalen Eingangssignal (INPUT(G) + Δt) stammt, und ein Anzeigesignal für abfallende Flanke (N) herstellen,
- ein Filtrierungsanzeigesignal für ansteigende Flanke (P') herstellen, ausgehend von dem digitalen Eingangssignal (INPUT(G)) und dem genannten Anzeigesignal für ansteigende Flanke (P),
- ein Filtrierungsanzeigesignal für abfallende Flanke (N') herstellen, ausgehend von dem digitalen Eingangssignal (INPUT(G)) und dem genannten Anzeigesignal für abfallende Flanke (N), und
- ein digitales Ausgangssignal (OUTPUT) ohne Spannungsspitze herstellen, ausgehend von dem Filtrierungsanzeigesignal für ansteigende Flanke (P') und dem Filtrierungsanzeigesignal für abfallende Flanke (N').

7. Filtrierungsverfahren für ein digitales Signal (INPUT(G)) nach Anspruch 6, **gekennzeichnet dadurch dass** das verzögerte digitale Eingangssignal (INPUT(G) + Δt) eine Verspätung (Δt) in Bezug auf das digitale Eingangssignal (INPUT(G)) aufweist, deren Länge mindestens gleich der maximalen Dauer einer Spannungsspitze (G) ist.

8. Modul (RTC) mit einem Rechtecksignalgenerator (CLK), der ein analoges Signal in ein digitales Eingangssignal (INPUT(G)) umwandelt, **gekennzeichnet dadurch, dass** es außerdem ein digitales Filter nach Anspruch 1 bis 5 umfasst, das fähig ist, besagtes digitale Eingangssignal (INPUT(G)) zu empfangen.

9. Mobiltelefon mit einem Modul (RTC) nach Anspruch 8.
